# EUROPEAN PATENT APPLICATION

(11) **EP 1 232 838 A1**
(43) Date of publication of application: **21.08.2002**
(21) Application number: 01104055.7
(22) Date of filing: 20.02.2001
(51) Int. Cl.: B25J 9/10, H01L 21/00

(54) **Frog-leg type transfer system**

(71) Applicant: Yokogawa Electric Corporation, Tokyo 180-8750 (JP)
(72) Inventor: Ishigame, Tooru, Musashino-shi, Tokyo 180-8750 (JP)
(74) Representative: Henkel, Feiler, Hänzel

(57) **Abstract**

The present invention relates to a transfer system and is characterized by the following:
the first and second upper arms (61,62) and the first and second forearms (66,67) are assembled in a frog-leg manner,
the first and second forearms (66,67) are linked with a forearm link (68),
the transfer hand (69,70) is attached to the above forearm link (68), and
the transfer hand is moved by associating the first upper arm (61) motion with the first (66) and second forearm (67) motions and associating the second upper arm (62) motion with the first (66) and second forearm (67) motions.

## Description

### [BACKGROUND OF THE INVENTION]

### 1. FIELD OF THE INVENTION

The present invention relates to a transfer system used for transfer of wafers in semiconductor manufacturing lines or the like.

### 2. DESCRIPTION OF THE PRIOR ART

In semiconductor manufacturing lines, a transfer system is used to move an object to be processed such as a wafer from a process to another process. Examples of such conventional transfer systems will be explained below.

### (1) Example 1 of conventional systems

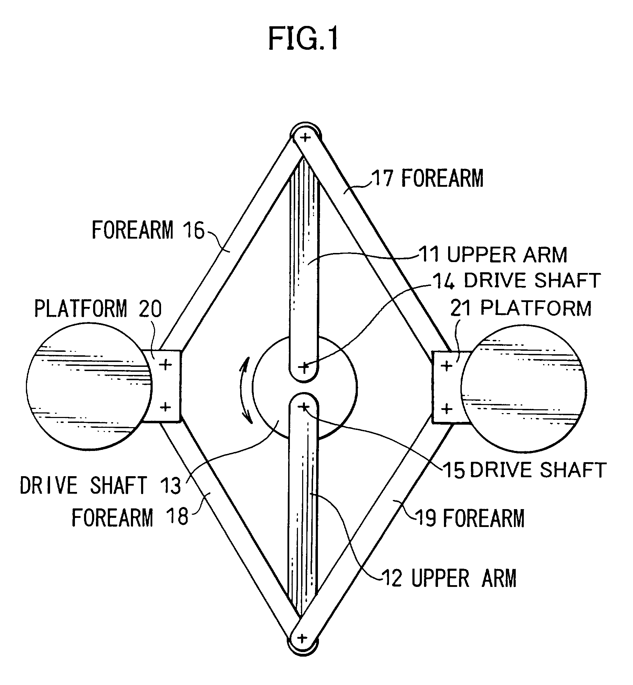

Figure 1 shows a configuration drawing of example 1 of conventional transfer systems.

In Figure 1, two upper arms 11 and 12 are positioned on drive shaft 13. Drive shaft 13 itself is designed to be driven by rotation. Upper arms 11 and 12 are linked with drive shafts 14 and 15. Upper arms 11 and 12 rotate on drive shaft 13. To the tip of upper arm 11, forearms 16 and 17 are rotatably mounted. To the tip of upper arm 12, forearms 18 and 19 are rotatably mounted. Platform 20 is linked with the tips of forearms 16 and 18 and platforms 21 with the tips of forearms 17 and 19.

As described above, four forearms 16 to 19 are assembled to form a pair of frog-legs. Platforms 20 and 21 are positioned depending on the rotated angles of upper arms 11 and 12.

Operations by this transfer system are described below.

By turning two upper arms 11 and 12 in opposite directions, one platform moves in the direction away from drive shaft 13 (distance from drive shaft 13 increases) and the other platform only slightly moves from its stand-by position. The other platform stays approximately at the same position as the stand-by position, where the stand-by position is the position above drive shaft 13.

In addition, by rotating drive shaft 13, the orientation of the frog-leg changes. This makes the extending direction of platforms 20 and 21 change. From these operations, two wafers are transferred by selecting either of two platforms 20 and 21 and extending or contracting that platform depending on the angle formed with two upper arms 11 and 12. Drive shaft 13 is rotated when a wafer whose process is completed is taken out of a process using a platform and is transferred to another process.

However, there are the following problems in example 1 of conventional systems:

If the direction of extension of platforms 20 and 21 is to be changed, drive shaft 13 is rotated with two platforms 20 and 21 placed in the stand-by position. In order to ensure that two platforms 20 and 21 do not hit adjacent machines, equipment, etc., the turning radius of the platforms must be made small. In order to make the turning radius small, platforms 20 and 21 must be made to come close to drive shaft 13. In order to make two platforms 20 and 21 come close to drive shaft 13, forearms 16 to 19 cannot be made thick. As a result, it is necessary to make the forearms very thin in example 1 of conventional systems and thus sufficient rigidity cannot be achieved. Therefore, there is a problem that the forearms are bent due to the weights of wafers and platforms, which prevents stable transfer, and there is another problem that the transfer speed cannot be increased.

### (2) Example 2 of conventional systems

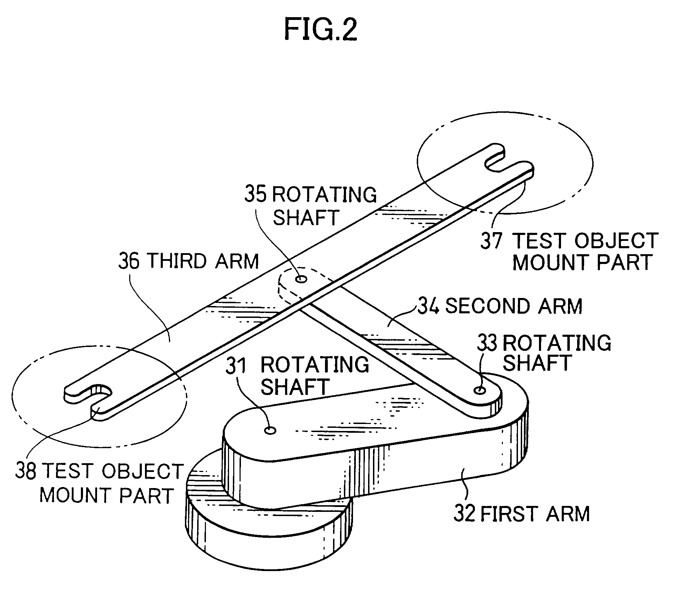

Figure 2 shows a configuration drawing of example 2 of conventional transfer systems.

In Figure 2, first arm 32 rotatable around rotating shaft 31 and second arm 34 rotatable around rotating shaft 33 located on the tip of first arm 32 are arranged. Further, third arm 36 rotatable around rotating shaft 35 located on the tip of second arm 34 is arranged. The center of rotation of third arm 36 is at the mid-point of the arm.

First arm 32 rotates directly coupled with the first motor (not shown) . Second arm 34 and third arm 36 rotate by the second motor and third motor (not shown) whose powers are transmitted by their respective pulleys and belts.

Such example 2 of conventional systems has Selective Compliance Assembly Robot Arm (SCARA) types of arms.

The test object mount parts 37 and 38 on which test objects are put respectively, are constructed at both ends of third arm 36.

Operations of example 2 of conventional systems will be described below.

The stand-by position is the position where first arm 32 and second arm 34 overlap each other. Rotation of first arm 32 in one direction causes test object mount part 37 or 38 located on either tip of third arm 36 to be placed in the extended position furthest from rotating shaft 31. The other test object mount part located on the opposite side is positioned in a place nearer to rotating shaft 31 than the above furthest test object mount part. Rotation of first arm 32 in the opposite direction moves the test object mount part on the opposite side to the furthest extended position via the stand-by position. In addition, the extending direction of a test object mount part is set at an arbitrary angle by turning the system around rotating shaft 31. Through the above operations, two wafers are transferred to other places by moving the above two test object (wafer, in this case) mount parts to the stand-by position or the furthest extended position.

However, there are the following problems in example 2 of conventional systems:

First arm 32 and second arm 34 are provided with a sealed barrier construction to exclude particles generated from the bearings that support the belts and pulleys, in order to comply with the degree of cleanliness required for semiconductor manufacturing. In addition, the widths of the belts depend on the strengths required for transmitting power, and so thicker arms must be designed to ensure the required belt widths and to establish barrier constructions.

However, in SEMI E21 and E22, which are standards for semiconductor manufacturing devices, standard dimensions of arms are defined. Specifically, the thickness of hands in interface zones for catching test objects is defined to be 23 mm for wafers up to 8 inches, that is, a very thin dimension is required. In example 2 of conventional systems, the coupling part of second arm 34 and third arm 36 corresponds to this zone. Making the thickness of the coupling part be 23 mm or less and providing barriers incorporating belts, pulleys and bearings in the arms result in fragile construction of the arms. Accordingly, there is a problem that the required arm thickness cannot be secured for such arm construction. There is another problem that the arms are likely to be bent due to the weight of wafers and test object mount parts because the arms are designed thin, and so stable transfer cannot be guaranteed.

### (3) Example 3 of conventional systems

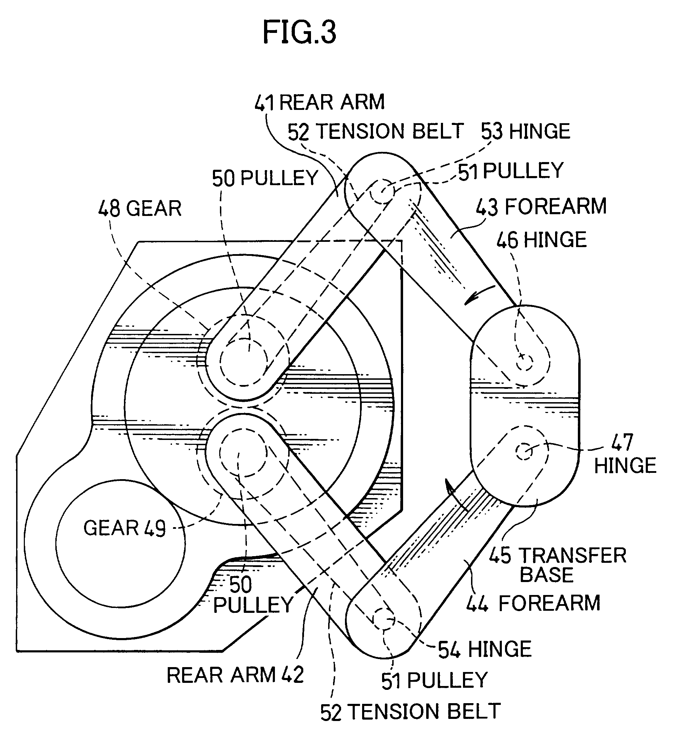

Figure 3 shows a configuration drawing of example 3 of conventional transfer systems.

In Figure 3, two forearms 43 and 44 are rotatably mounted on the tips of two rear arms 41 and 42; furthermore, transfer base 45 is linked with the tips of forearms 43 and 44 using hinges 46 and 47. These constitute a frog-leg shaped arm.

Rear arms 41 and 42 are rotated with gears 48 and 49 that rotate in opposite directions to each other synchronously. Forearms 43 and 44 are each rotated by pulleys 50 and 51 having the effective diameter ratio of 2 to 1 and tension belt 52 stretched between both pulleys 50 and 51. Each pulley 50 is tightly fixed in a coaxial manner to gears 48 and 49. Each pulley 51 is tightly fixed in a coaxial manner to hinges 53 and 54.

Operations of example 3 of conventional systems will be described below.

Forearms 43 and 44 rotate by 2α that is twice the deflection angle α of each of two rear arms 41 and 42 when these rear arms turn in opposite directions to each other and transfer base 45 is positioned. The rotating angles and rotating directions of forearms, which are restricted by pulleys 50 and 51 and belt 52, correspond to the rotating positions of rear arms. Therefore, transfer base 45 is positioned by the rotation of each rear arm in the range of ±90° in opposite directions starting at the status in which each of the forearms and rear arms overlap.

However, there are the following problems in example 3 of conventional systems:

This arm construction is essentially equivalent to an arrangement in which two SCARA type robots are placed in parallel. So, it is a mere addition of power transmission means such as gears 48 and 49 that make two rear arms 41 and 42 turn in opposite directions to hold the arm driving motor in common.

Two rear arms must be arranged so as to come close to each other and thus thick gears 48 and 49 cannot be designed, so the bearing rigidity is lowered and the arms become thin. Consequently, there is a problem that the arms are likely to be bent and stable transfer cannot be performed. In addition, if semiconductor wafers are to be transferred in vacuum, the drive shaft must be vacuum-sealed from the surrounding area. However, if gears 48 and 49 linking with two rear arms 41 and 42 are required independently, each one must be sealed separately. Consequently, there is another problem that the construction becomes complicated, and so additional maintenance time and labor are required.

Considering the relationship between arms and motors, to move the construction either in the arm extending direction (hereafter called R-axis) or in the arm turning direction (hereafter called θ-axis), any of the configurations of examples 1 to 3 is provided with an R-axis motor and a θ-axis motor. When extending or turning the construction, either of the motors operates and the other motor does not operate. For this reason, there is a common problem that the availability of the motors is not so good.

### [SUMMARY OF THE INVENTION]

The present invention is intended to solve the problems of the above examples 1 to 3. The purposes of the present invention are to guarantee stable transfer operations and to offer transfer systems in which maintenance is easy and energy is saved.

### [BRIEF DESCRIPTION OF DRAWINGS]

Figure 1 shows a configuration drawing of an example of conventional transfer systems.
Figure 2 shows a configuration drawing of another example of conventional transfer systems.
Figure 3 shows a configuration drawing of a further example of conventional transfer systems.
Figure 4 shows a configuration drawing of one embodiment of the present invention.
Figure 5 is a plan of the transfer system shown in Figure 4 viewed from above.
Figure 6 is a drawing indicating an example of the power transmission mechanism in the transfer system shown in Figures 4 and 5.
Figure 7 is another drawing indicating an example of the power transmission mechanism in the transfer system shown in Figures 4 and 5.
Figure 8 is also another drawing indicating an example of the power transmission mechanism in the transfer system shown in Figures 4 and 5.
Figure 9 is also another drawing indicating an example of the power transmission mechanism in the transfer system shown in Figures 4 and 5.
Figure 10 shows drawings illustrating operation of the transfer system shown in Figures 4 and 5.
Figure 11 shows drawings illustrating operation of the transfer system shown in Figures 4 and 5.
Figure 12 shows a drawing illustrating operation of the transfer system shown in Figures 4 and 5.
Figure 13 shows drawings indicating an example of the configuration of the forearm link.
Figure 14 is a drawing illustrating operation of the transfer system shown in Figures 4 and 5.
Figure 15 is another drawing illustrating operation of the transfer system shown in Figures 4 and 5.
Figure 16 is also another drawing illustrating operation of the transfer system shown in Figures 4 and 5.
Figure 17 shows drawings indicating an example of the transfer sequence of transferring wafers.
Figure 18 shows a configuration drawing of another embodiment of the present invention.

### [DESCRIPTION OF THE PREFERRED EMBODIMENTS]

The present invention will be described below in detail with reference to the drawings. The present invention is explained using an embodiment.

### (Embodiment 1)

The present invention is described below in detail with reference to the drawings.

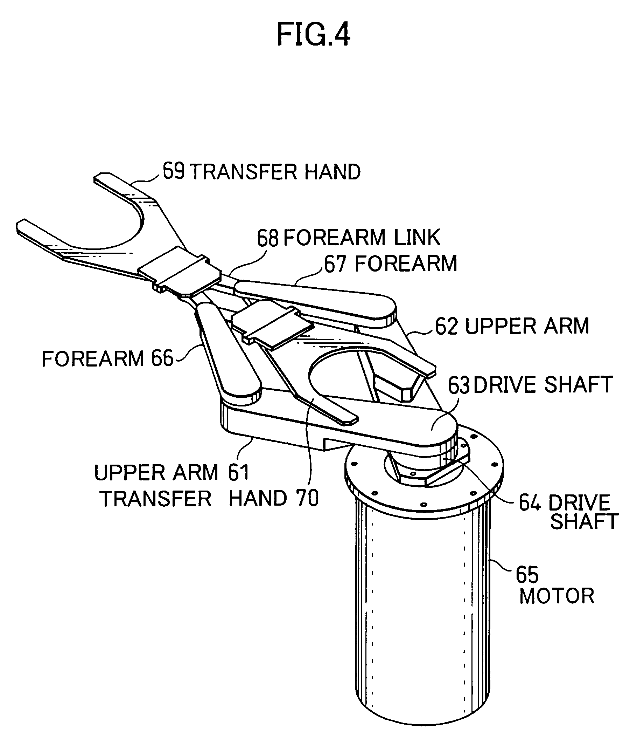

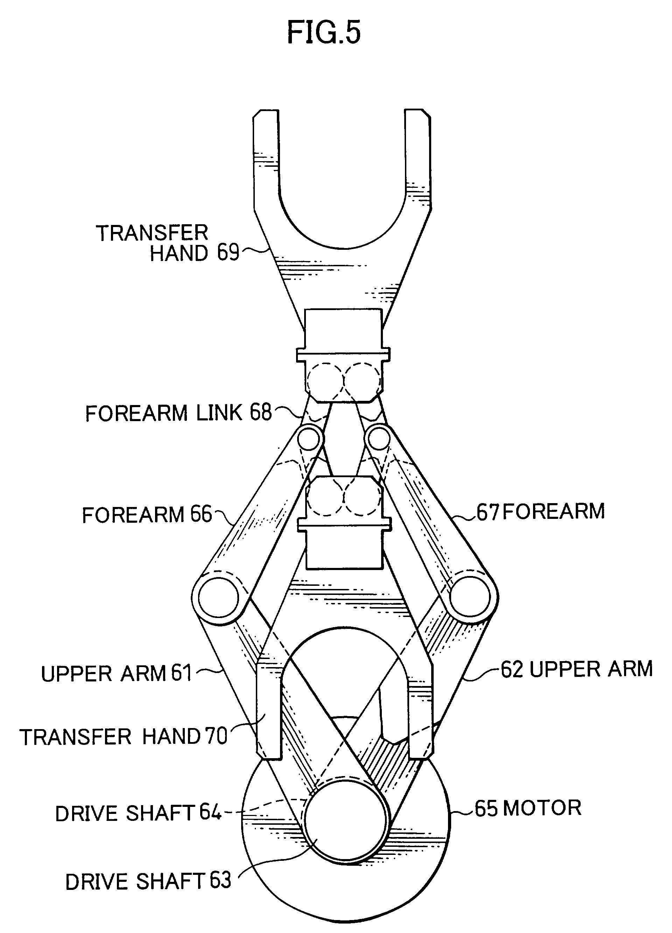

Figure 4 shows a configuration drawing of one embodiment of the present invention. Figure 5 is a plan of the transfer system shown in Figure 4 viewed from above.

In Figures 4 and 5, upper arms 61 and 62 are each rotatable in a coaxial manner.

Drive shafts 63 and 64 drive upper arms 61 and 62 respectively.

Motor 65 is a two-shaft motor having two output shafts driven independently to each other. The two output shafts of motor 65 are directly coupled with drive shafts 63 and 64 respectively. The two output shafts of motor 65 are arranged in a coaxial manner. Such motor 65 is, for example, a motor mentioned in the filing specification of patent application, No. Hei 3-16597, prepared by the applicant of the present invention.

The base end of forearm 66 is mounted rotatably on the tip end of upper arm 61.

The base end of forearm 67 is mounted rotatably on the tip end of upper arm 62.

Both tip ends of forearms 66 and 67 are linked with forearm link 68.

Transfer hands 69 and 70 are attached to forearm link 68 and are arranged in different transfer directions to each other.

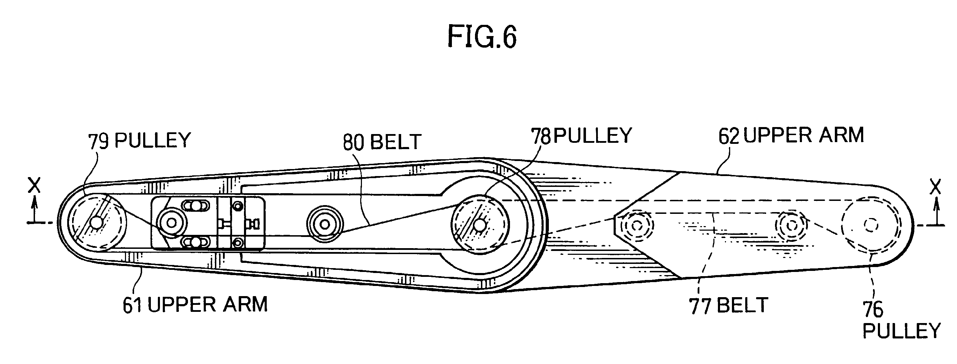

An example configuration of the power transmission mechanism in the transfer system shown in Figures 4 and 5 will be described using Figures 6 to 9.

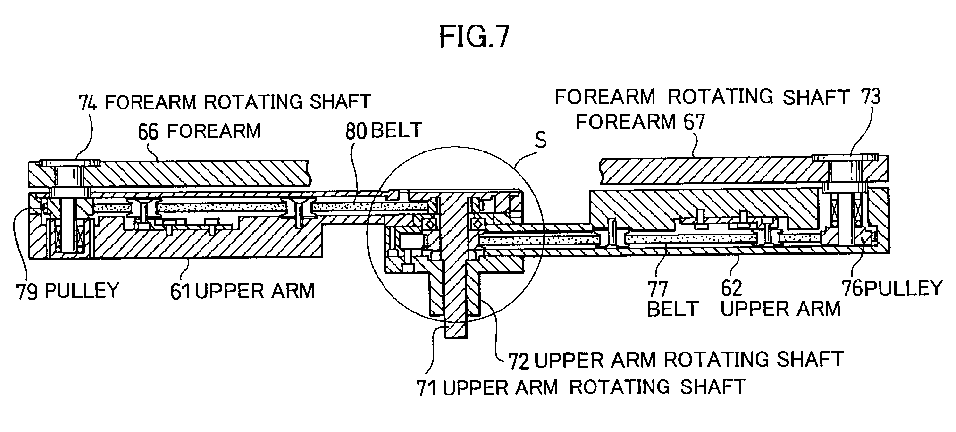

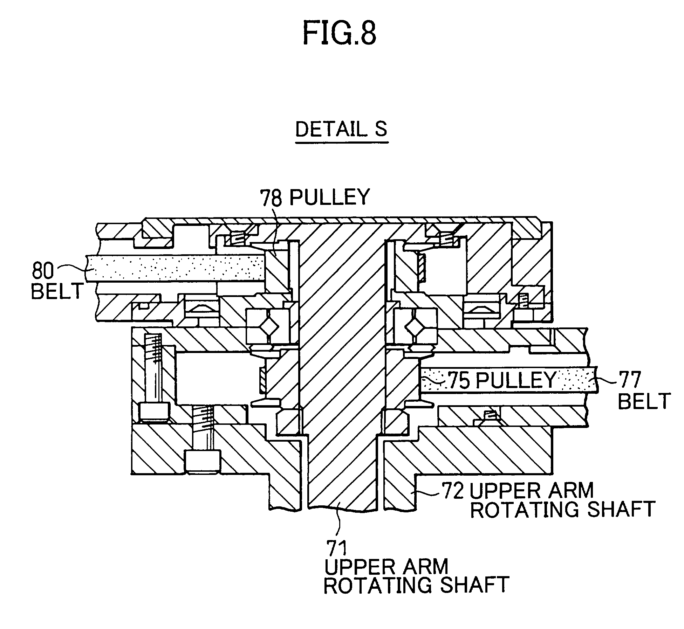

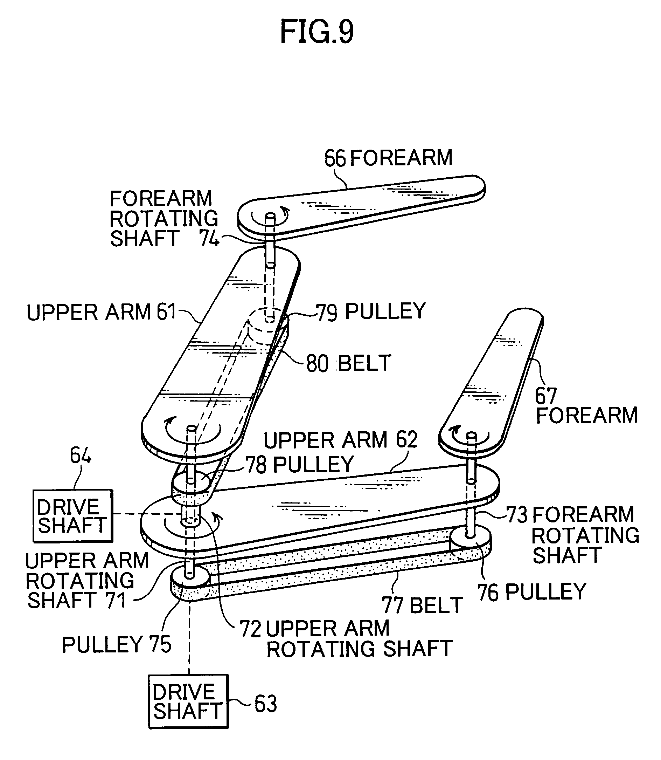

Figures 6 to 8 show cross-sectional views of the power transmission mechanism and Figure 9 shows a conceptual and schematic drawing of the power transmission mechanism. Figure 6 shows a plan of the upper arm, Figure 7 shows a cross-sectional view of portion X-X of Figure 6, and Figure 8 shows an enlarged drawing of part S in Figure 7.

In these figures, upper arm drive shafts 71 and 72 are arranged in a coaxial manner. Upper arm drive shaft 71 is coupled with upper arm 61 and upper arm drive shaft 72 with upper arm 62.

Forearm 67 is coupled with forearm drive shaft 73 provided at the tip end of upper arm 62. Forearm 66 is coupled with forearm drive shaft 74 provided at the tip end of upper arm 61.

Drive shaft 63 is linked with upper arm drive shaft 71 and transmits power to upper arm 61 via upper arm drive shaft 71.

Drive shaft 64 is linked with upper arm drive shaft 72 and transmits power to upper arm 62 via upper arm drive shaft 72.

Pulley 75 is coupled with upper arm drive shaft 71 and pulley 76 is coupled with forearm drive shaft 73. Belt 77 is passed around pulleys 75 and 76.

The torque of drive shaft 63 is transmitted to upper arm 61 via upper arm drive shaft 71. The torque of drive shaft 63 is also transmitted to forearm 67 via upper arm drive shaft 71, pulley 75, belt 77, pulley 76 and forearm drive shaft 73. Upper arm 61 and forearm 67 are driven associated with each other because of the above construction.

In a similar manner, pulley 78 is coupled with upper arm drive shaft 72 and pulley 79 is coupled with forearm drive shaft 74. Belt 80 is passed around pulleys 78 and 79.

The torque of drive shaft 64 is transmitted to upper arm 62 via upper arm drive shaft 72. The torque of drive shaft 64 is also transmitted to forearm 66 via upper arm drive shaft 72, pulley 78, belt 80, pulley 79 and forearm drive shaft 74. Upper arm 62 and forearm 66 are driven associated with each other because of the above construction.

If any one of the upper arms is rotated, the relative angle between upper arm 61 and upper arm 62 varies.

Accordingly, if drive shaft 63 is rotated, upper arm 61 and forearm 67 rotate in the same direction and at the same time forearm 66 is relatively rotated in the opposite direction. Since the positions of pulleys 78 and 79 around which belt 80 is passed vary by the rotation of upper arm 61, forearm 66 rotates.

In a similar manner, if drive shaft 64 is rotated, upper arm 62 and forearm 66 rotate in the same direction and at the same time forearm 67 is relatively rotated in the opposite direction.

The ratio of radii of pulleys 75 and 76 and the ratio of radii of pulleys 78 and 79 are both 1 to 1. When upper arm 62 rotates, the above makes forearm 66 rotate by the same angle as upper arm 62 in the same direction, and makes forearm 67 rotate by the same angle in the opposite direction. In addition, when upper arm 61 rotates, forearm 67 rotates by the same angle as upper arm 61 in the same direction, and forearm 66 rotates by the same angle in the opposite direction.

In this case, the ratio of radii of pulleys 75 and 76 and the ratio of radii of pulleys 78 and 79 may be taken as a value other than 1 to 1.

As shown in Figures 6 to 9, the configuration is such that upper arms 61 and 62 rotate in a coaxial manner and each bearing is stacked up on the drive shafts. Thus, the values of the shaft diameters are not specifically restricted and can be selected suitably depending on the load.

In addition, the four arms of upper arms 61 and 62 and forearms 66 and 67 are positioned in a stacked manner and thus their moving regions for rotation do not interfere with each other. This does not restrict the horizontal arm widths orthogonal to the drive shafts. So, the arm widths can be set corresponding to the load.

Further, since there are no pulleys and belts inside forearms 66 and 67, thin forearms can be designed that easily comply with the arm dimensions defined in the SEMI E21 and E22 standards.

In addition to the above, the fact that the drive shaft comprises two shafts that are arranged in a coaxial manner, simplifies the transmission mechanism because the motor shafts can be directly coupled with the mechanism. Furthermore, vacuum sealing is easy to perform for applications in an evacuated atmosphere, and the simple construction improves maintainability.

Operations of the embodiment shown in Figures 4 to 9 will be described below.

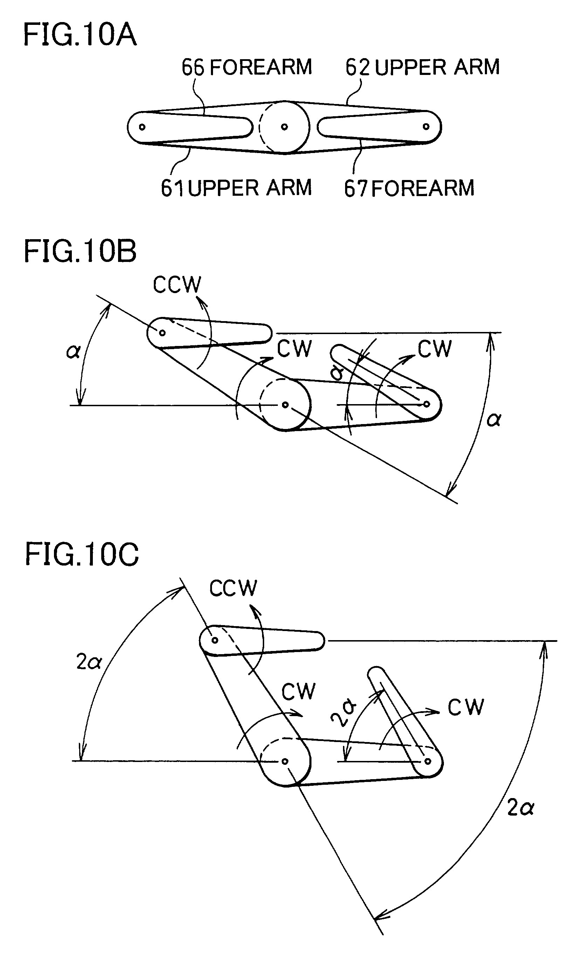

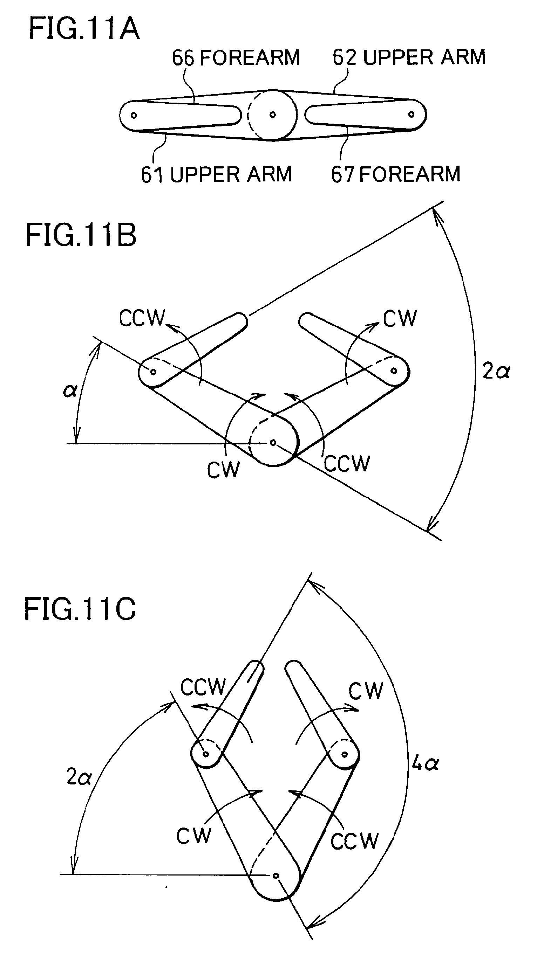

Figures 10 and 11 show drawings illustrating operations.

Figure 10 shows drawings illustrating operations if any one upper arm is rotated, and Figure 11 shows drawings illustrating operations if two upper arms are rotated in opposite directions.

Figure 10 shows operations if only upper arm 61 is rotated.

In Figure 10, drawing (A) shows the stand-by position, drawing (B) an extended position in which the upper arm is rotated by angle α, and drawing (C) an extended position in which the upper arm is rotated by angle 2α. The radius ratio of pulleys 75 and 76 and that of pulleys 78 and 79 are both assumed to be 1 to 1 in this embodiment.

In the stand-by position (starting point at angle zero) shown in drawing (A) of Figure 10, forearms and upper arms are stacked on a straight line. Rotating centers of each arm are positioned on a straight line.

In drawing (B) of Figure 10, if upper arm 61 is rotated by angle α clockwise (CW), forearm 67 is rotated by angle α clockwise (CW) and forearm 66 is relatively rotated by angle α counterclockwise (CCW).

In drawing (C) of Figure 10, if upper arm 61 is rotated by angle 2α clockwise (CW), forearm 67 is rotated by angle 2α clockwise (CW) and forearm 66 is relatively rotated by angle 2α counterclockwise (CCW).

The conditions shown in drawings (A), (B) and (C) of Figure 11 are similar to the conditions shown in drawings (A), (B) and (C) of Figure 10.

The stand-by position (starting point at angle zero) shown in drawing (A) of Figure 11 is the same as shown in drawing (A) of Figure 10.

In drawing (B) of Figure 11, when upper arm 61 and upper arm 62 are rotated by angle α clockwise (CW) and counterclockwise (CCW) respectively, forearm 67 and forearm 66 are rotated by angle 2α clockwise (CW) and counterclockwise (CCW) respectively.

In drawing (C) of Figure 11, when upper arm 61 and upper arm 62 are rotated by angle 2α clockwise (CW) and counterclockwise (CCW) respectively, forearm 67 and forearm 66 are rotated by angle 4α clockwise (CW) and counterclockwise (CCW) respectively.

If the radius ratios of pulleys are 1 to 1, upper arm 61 and forearm 67 are always parallel with each other assuming that errors in pulley diameters and elongation of belts are neglected and, similarly, upper arm 62 and forearm 66 are also kept parallel with each other.

In addition, if drawing (C) of Figure 10 is compared with drawing (B) of Figure 11, the relative positions of upper arms and forearms show the same attitude in both cases, only by rotating upper arms by angle α. This shows that, even if either one or both of upper arms are rotated, the attitude of the upper arms and forearms depends on the relative angle between upper arms 61 and 62.

As described above, according to the rotation angle of upper arms 61 and 62, the rotation angle of a pair of forearms 66 and 67 is uniquely determined.

In Figures 10 and 11, the case where upper arm 61 is rotated clockwise (CW) starting at the stand-by position (A) as an example is described. However, the situation is the same if upper arm 61 is rotated counterclockwise (CCW), and in this case the attitude of forearms relative to the upper arms is also uniquely determined.

Accordingly, depending on the rotating direction of upper arms 61 and 62 turning in opposite directions, the arms can be operated in both directions making a straight line connecting rotating centers of the upper arms and forearms in the attitude in the stand-by position (A) as the axis of symmetry.

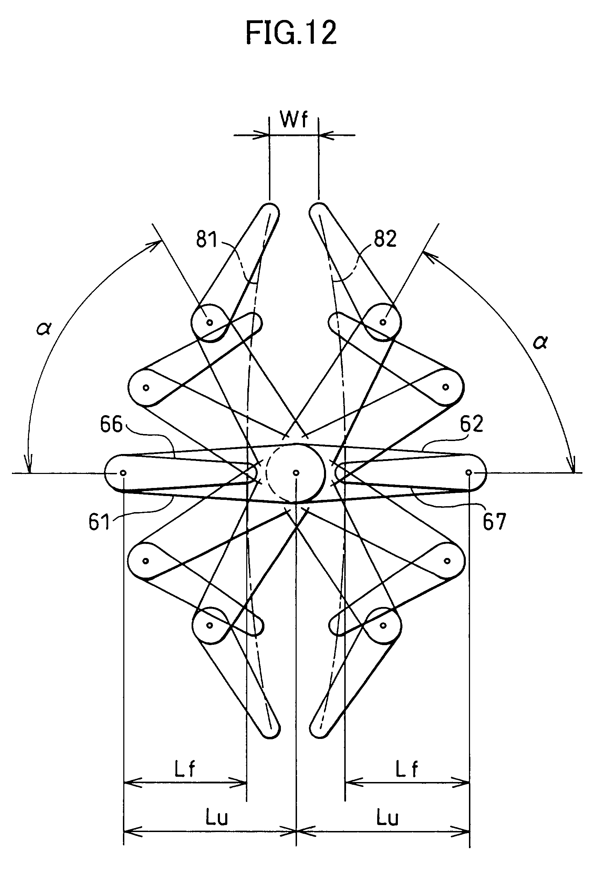

Figure 12 shows the loci of upper arms 61 and 62 and forearms 66 and 67 when they are operated in both directions.

In this case, let the length from the rotating center of upper arm 61 to the rotating center of forearm 66 be Lu, the length from the rotating center of forearm 66 to an arbitrary tip end of forearm 66 be Lf, and the rotating angle of forearm 67 be α. Further assume that the same definition applies to the relation between upper arm 62 and forearm 67. Then the distance Wf between the arbitrary tip ends located on forearms 66 and 67 can be determined using the equation 2 × (Lu·cos α - Lf·cos α) if the radius ratios of the above-mentioned pulleys are 1 to 1. Consequently, the positions of arbitrary tip ends of forearms 66 and 67 based on the rotation of upper arms 61 and 62 take courses expressed by loci 81 and 82 and their distance is uniquely determined.

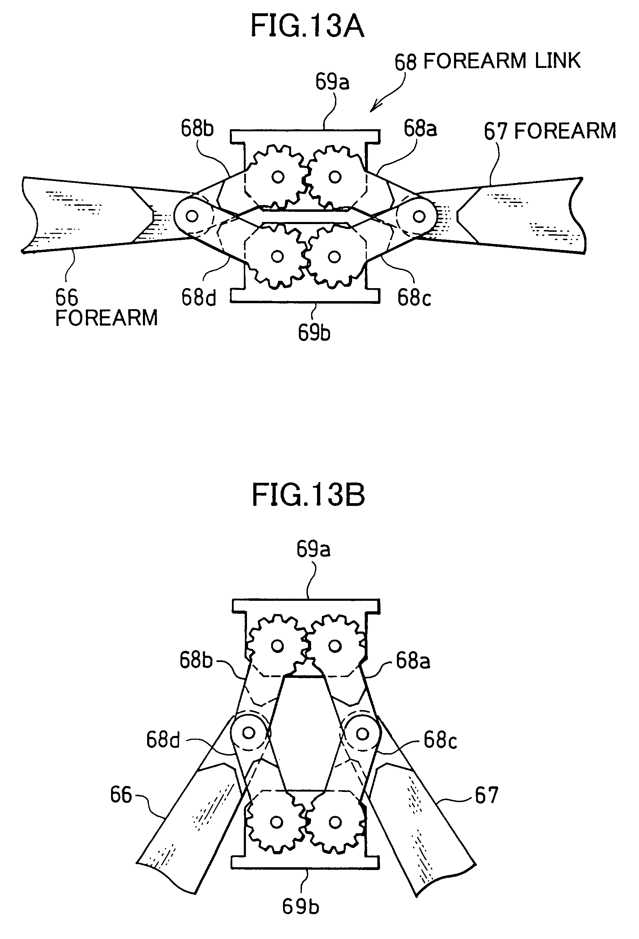

Figure 13 shows drawings indicating an example of the configuration of forearm links.

In Figure 13, drawing (A) shows the status of forearm links in the case where upper arms and forearms are located in the stand-by position and drawing (B), the status of forearm links in the case where upper arms and forearms are placed in an extended position.

In Figure 13, two linking members 68a and 68c are coupled with forearm 67 with a pin, the tip end of linking member 68a is coupled with transfer hand 69a with a pin, and the tip end of linking member 68c is coupled with transfer hand 69b with a pin.

Similarly, transfer hands 69a and 69b are supported with forearm 66 via linking members 68b and 68d. The constructions of each of linking members 68a and 68b and linking members 68c and 68d are made so as to engage with gears so that they are rotated in transfer hands 69a and 69b synchronized with each other in opposite directions. However, the linking members may be restricted through friction by being given preliminary pressures or these gears may be replaced with a figure-of-eight belt. From the fact that these four forearm linking members 68a, 68b, 68c and 68d function as links, each position of transfer hands 69a and 69b is restricted for any position taken by forearms 66 and 67.

In such a manner, a frog-leg type arm whose motion is bi-directional driven by two coaxial shafts can be composed through a combination of four forearms and upper arms with forearm links and transfer hands.

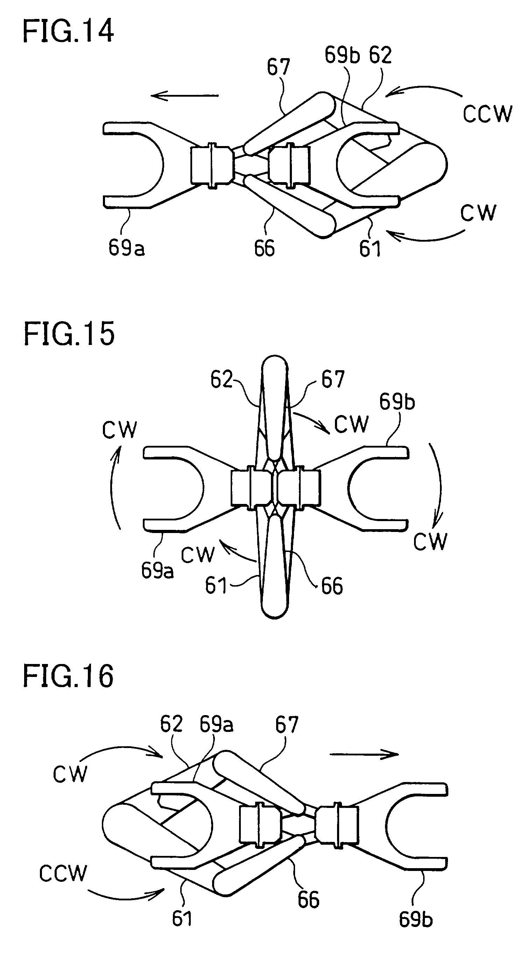

Figures 14 to 16 show the direction of motion of transfer hands against the rotating direction of upper arms.

As shown in Figure 14, if upper arm 61 is rotated clockwise (CW) and upper arm 62 is rotated counterclockwise (CCW), transfer hand 69a operates in its extended direction.

As shown in Figure 15, upper arms 61 and 62 are rotated in the same direction (for example, in the clockwise (CW) direction), and transfer hands 69a and 69b rotate in the same direction as upper arms 61 and 62 around the rotating shafts of the upper arms. In Figure 15, the case of rotating in the stand-by position where upper arms and forearms overlap with each other is shown as an example.

As shown in Figure 16, if upper arm 61 is rotated counterclockwise (CCW) and upper arm 62 is rotated clockwise (CW), transfer hand 69b operates in its extended direction.

As mentioned above, a frog-leg type arm whose motion is bi-directional driven by two coaxial shafts can be operated, arbitrarily determining each extended direction of transfer hands 69a and 69b and the direction in which the entire arm rotates, by combining the rotating directions of upper arms 61 and 62. This makes two wafers transferred in turn.

In the case of operation either by extending the frog-leg type arm or by rotating the arm, the torque required for each output power shaft of a two-shaft motor becomes 1/2. It is because two drive shafts that drive two upper arms 61 and 62 share the load by always being driven. Thus, a smaller output motor can be used.

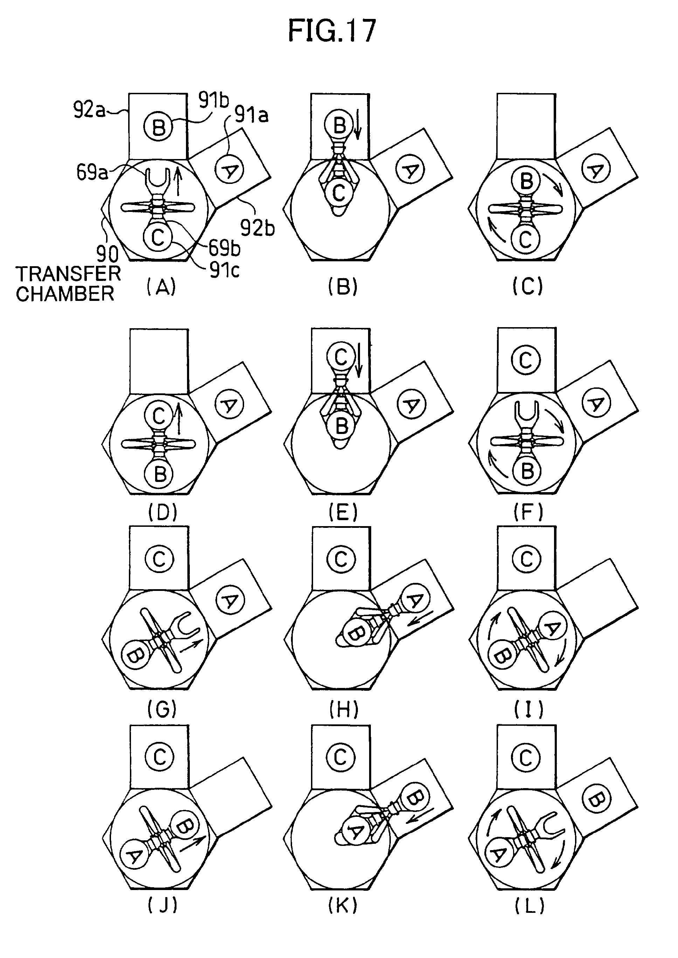

Figure 17 shows drawings indicating an example of the transfer sequence of transferring wafers.

In drawing (A) of Figure 17, the transfer arm of the present invention is positioned at the center of transfer chamber 90. Drawing (A) of Figure 17 also shows a status in which first and second wafers 91a and 91b (hereafter called wafer A and wafer B) are subjected to semiconductor process treatments in second process treatment cell 92b and first process treatment cell 92a, respectively. These process treatment cells are radially arranged at different angles to the center of transfer chamber 90. The sequence of the processes is such that the first process is located on the upstream side and the second process is located on the downstream side. The process stream is directed from wafer B to wafer A. The transfer arm has third wafer 91c (hereafter called wafer C) on transfer hand 69b in the status of the stand-by position.

Drawings (A) to (L) of Figure 17 show the following treatments:
(A) and (B): Wafer B in the first process treatment cell is unloaded.
(C) and (D): Wafer C is indexed to the first process treatment cell.
(D) and (E): Wafer C is loaded in the first process treatment cell.
(F) and (G): An empty transfer hand is indexed to the second process treatment cell.
(G) and (H): Wafer A is unloaded.
(I) and (J): Wafer B is indexed to the second process treatment cell.
(J) and (K): Wafer B is loaded in the second process treatment cell.
(L): An empty transfer hand is indexed to the next process treatment cell.

By repeating a series of these operations, wafers are transferred to each process according to a predetermined sequence. Although transfer over two processes is described here as an example, the present invention does not restrict the number of transfer processes.

Any number of processes for transfer objects may be selected, and the direction of transfer and transfer sequence can be taken arbitrarily.

The embodiment shown in Figures 4 to 17 gives the following effects:
(1) Since the drive shafts are directly coupled with the output power shafts of the motor, the transmission mechanism is simplified, vacuum sealing is easy to perform for applications in an evacuated atmosphere, and the simple construction improves maintainability.
(2) Since the centers of rotation of the upper arms are arranged in a coaxial manner, each bearing takes a configuration stacked on the drive shaft. This makes it possible to suitably select the diameter of bearings according to the load without specific restriction for the shaft diameter. As a result, a bearing assembly having sufficient rigidity can be designed and thus the rigidity of transfer systems can be increased.
(3) When the first upper arm rotates driven by the first drive shaft, the second forearm is rotated in the same direction as the first upper arm rotation and the first forearm is rotated in the opposite direction respectively in association with the motion of the drive shaft. When the second upper arm rotates driven by the second drive shaft, the first forearm is rotated in the same direction as the second upper arm rotation and the second forearm is rotated in the opposite direction respectively in association with the motion of the drive shaft. For this reason, operations of extending or contracting the transfer arm and of changing the orientation of the transfer arm can be performed by selecting the rotating directions of the first and second drive shafts. Since this makes it possible to use the same motor for extending or contracting the transfer arm and for changing the orientation of the transfer arm, the power required for transfer motion can be reduced and the configuration can be simplified.
(4) Since the transmission means transmits power at the transmission ratio of 1 to 1, the upper arms and forearms positioned on opposite arms of the parallelogram can be rotated with parallelism maintained.
(5) Since the transmission means are provided on the sides nearer to the drive shafts than the base ends of the forearms, the forearms can be designed thinner and thus it is easier to comply with the arm dimensions defined in standards SEMI E21 and E22.
(6) A transfer hand can be moved from a position on one side of the drive shafts to a position on the other side of the drive shafts passing over the position of the drive shafts. By giving versatility to the transfer hands moving range, the attitude of the transfer hands when they rest in the stand-by position can be such that the transfer hands and each arm project the minimum amount from the system. This makes it possible to reduce the turning radius of the entire system.
(7) Two transfer hands can be mounted on the forearm links. Since they are arranged in different transfer directions from each other, if they are applied to semiconductor processes, they can hold a wafer to be loaded to a process treatment cell and that unloaded from that process treatment cell at the same time. This can improve the transfer efficiency.
(8) Since each of the upper arms and forearms is arranged in a stacked manner and so do not interfere with each other's range of movement when they are rotated, the widths of each in the horizontal direction orthogonal to the rotating shafts are not specifically restricted. Thus, they can be set to widths corresponding to the load.

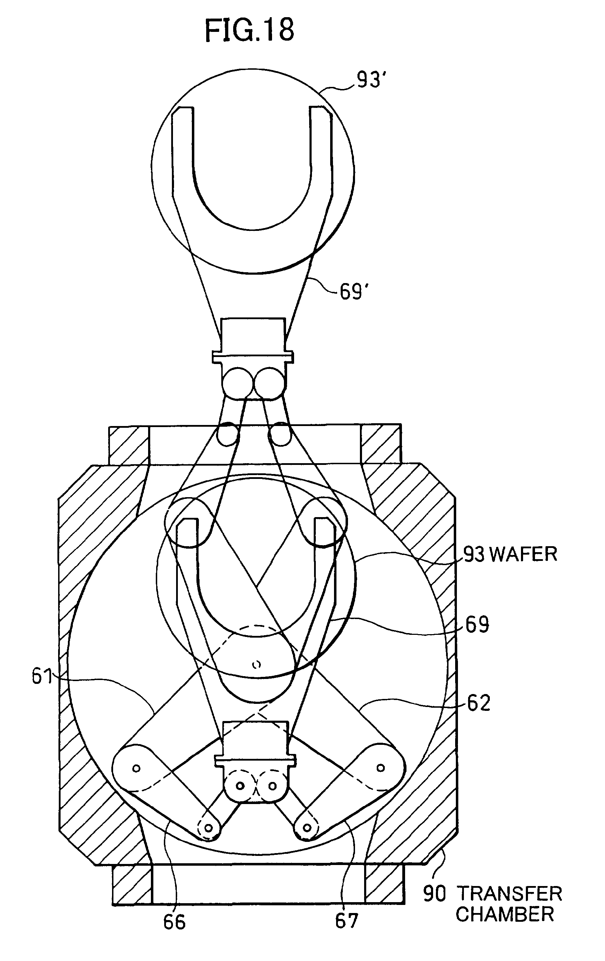

Figure 18 shows a configuration drawing of another embodiment of the present invention.

In this embodiment, a transfer system that occupies less space is achieved by providing one transfer hand.

In Figure 18, a transfer system attitude in the withdrawn position is shown, in which
the driving centers of upper arms 61 and 62 are located in the center of transfer chamber 90, and
one transfer hand 69 which holds wafer 93 is arranged in the tip ends of forearms 66 and 67.
In addition, transfer hand 69' and wafer 93' drawn with chain double-dotted lines show the arm-extended position. In this embodiment, there is no transfer hand on one side. Therefore, even if the arm-withdrawn position attitude is such that the arms are withdrawn to a position in which wafer 93 overlaps the rotating center of upper arms 61 and 62, the turning radius for the entire arms including the wafer can be made small.

Accordingly, for cases where a set of transfer arms is used in combination with one process module that handles and processes semiconductors (called single chamber system), the positioning distances between adjacent processes can be reduced. Thus, a clean room, the area of which incurs a high land cost, can be effectively utilized by reducing the area occupied by the transfer system. In particular, a compact transfer system can be offered for large-size wafers and is an effective transfer means for wafers whose sizes are becoming increasingly large.

As described above, the present invention can guarantee stable transfer motions because the arms have sufficient rigidity and can offer transfer systems that are easy to maintain and that conserve energy.

## Claims

1. A transfer system comprising:
the first and second upper arms provided rotatably in a coaxial manner, the first and second drive shafts arranged in a coaxial manner, that drive said first and second upper arms respectively, directly coupled with an output power shaft of a motor,
the first forearm whose base end is rotatably mounted on the tip end of said first upper arm,
the second forearm whose base end is rotatably mounted on the tip end of said second upper arm,
a forearm link in which the tip ends of said first and second forearms are linked,
a transfer hand attached to the forearm link,
the first transmission means that transmits the power of said first drive shaft to said second forearm, and
the second transmission means that transmits the power of said second drive shaft to said first forearm;
further moving said transfer hand through rotation of these arms,
said second forearm rotating in the same direction of, and said first forearm rotating in the opposite direction of rotation of said first upper arm respectively, associated with this first upper arm rotation, when said first upper arm is rotated driven by said first drive shaft,
said first forearm rotating in the same direction of, and said second forearm rotating in the opposite direction of rotation of said second upper arm respectively, associated with this second upper arm rotation, when said second upper arm is rotated driven by said second drive shaft.

2. A transfer system in accordance with claim 1, wherein
said first and second transmission means transmit power at the transmission ratio of 1 to 1,
when said first upper arm is rotated, the second forearm rotates in the same direction of, and the first forearm rotates in the opposite direction of rotation of said first upper arm by the same angle as said first upper arm rotation angle, and
when said second upper arm is rotated, the first forearm rotates in the same direction of, and the second forearm rotates in the opposite direction of rotation of said second upper arm by the same angle as said second upper arm rotation angle.

3. A transfer system in accordance with claim 1, wherein said first and second transmission means are provided on the side of the base end of said forearms nearer to the drive shafts and transmit power between the rotating centers of forearms and the rotating centers of upper arms respectively.

4. A transfer system in accordance with claim 1, wherein
said first and second upper arms can be rotated in both clockwise and counterclockwise directions starting at the status in which they overlap with said first and second forearms, and
said transfer hand can move from a position on one side of said first and second drive shafts to a position on the other side of said drive shafts passing over the position on said first and second drive shafts.

5. A transfer system in accordance with claim 1, wherein two of said transfer hands are attached to the forearm link and these transfer hands are arranged in opposite directions to each other.

6. A transfer system in accordance with claim 1, wherein said first and second upper arms and said first and second forearms are positioned in a stacked manner and thus the region of movement of each arm does not interfere with each other when the arms are rotated.
